# EUROPEAN PATENT APPLICATION

(11) **EP 0 933 878 A1**
(43) Date of publication of application: **04.08.1999**
(21) Application number: 98300557.0
(22) Date of filing: 27.01.1998
(51) Int. Cl.: H04B 1/036, H05K 7/20

(54) **Cooling system for radio telecommunications equipment**

(71) Applicant: LUCENT TECHNOLOGIES INC., Murray Hill, New Jersey 07974-0636 (US)
(72) Inventor: Bestwick, Graham Spencer, Lambourne, Berks, RG17 8YZ (GB)
(74) Representative: Funnell, Samantha Jane

(57) **Abstract**

Radio telecommunications equipment is disclosed having an enclosure 2 mounted outdoors. The enclosure contains a radio transmitter and a radio receiver.

A cooling module 12 is mounted adjacent the enclosure to force air over the surface of the enclosure thereby to cool it.

A mains splitter unit 20 has a mains inlet 18 connected to a mains electrical supply by cable, and two mains outlets connected by cable and connectors one to power the transmitter and receiver in the enclosure and the other to power the cooling module.

A switch 30 isolates the second outlet from the mains supply.

The arrangement allows the cooling unit to be replaced without powering down the radio equipment whilst retaining the necessity for use of a only single cable to the mains supply.

## Description

This invention relates to radio telecommunications equipment.

The background to the invention will be described with reference to a particular application, namely base station equipment in a cellular mobile telecommunications network. Other application of the invention may readily occur to the reader.

In a cellular mobile telecommunications network, base stations radio equipment is located at sites chosen for their geographical suitability. The sites are usually a significant distance from the nearest mains supply.

In some locations it is possible to cool the equipment without forced convection. In other locations forced convection is necessary. In order to avoid supplying all equipment with forced cooling, when it will often be unnecessary, and to avoid producing two separate units, one force cooled the other not, it is proposed to provide an add on cooling unit.

In a prior proposal, a mains supply was fed, via a supply cable and plug and socket connectors, to the cooling unit. Cable and plug and socket connectors then connected the supply from the cooling unit to the radio equipment in the enclosure. The arrangement avoids separate cabling from the mains supply to the cooling unit and the enclosure but has operational difficulties. An isolator allowed maintenance work to be done on the cooling unit without interrupting power to the enclosure. However, if the cooling unit required replacement, the radio equipment had to be powered down.

Against this background, there is provided radio telecommunications equipment, comprising:
an enclosure mounted outdoors, the enclosure containing a radio transmitter and a radio receiver;
a cooling module mounted adjacent the enclosure to force air over the surface of the enclosure thereby to cool it;
a mains splitter unit having a mains inlet connected to a mains electrical supply by cable, and two mains outlets connected by cable and connectors a first outlet to power the transmitter and receiver in the enclosure and a second outlet to power the cooling module; and
a switch to isolate the second outlet from the mains supply.

The arrangement allows the cooling unit to be replaced without powering down the radio equipment whilst retaining the necessity for use of a only single cable to the mains supply.

The preferred embodiment is a base station equipment in a mobile telecommunications network.

The enclosure is preferably formed with heat conductive extended surfaces extending vertically, in use, so as to define channels therebetween; the equipment including an outer case containing said enclosure and defining air passages into which the extended surfaces project, the outer case having vents to allow convection through the channels between the extended surfaces; the cooling module being located at or towards the upper end of the air passages to draw air therefrom.

The splitter unit is preferably a separate module mounted in the outer casing.

One embodiment of the invention will now be described with reference to the accompanying drawings, in which:

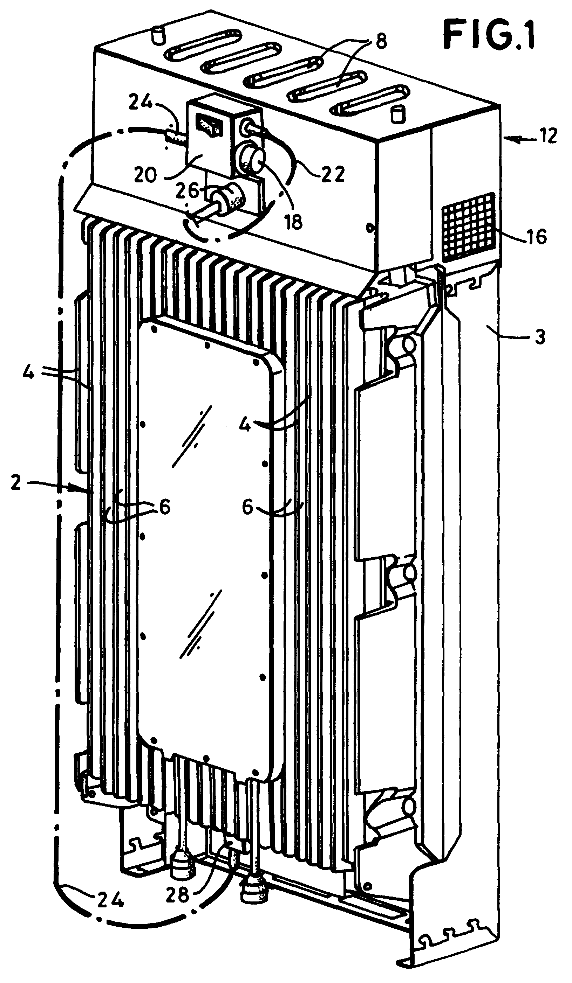

Figure 1 is a pictorial view of a base station equipment for a mobile cellular telecommunications network embodying the invention with part of its cover removed;

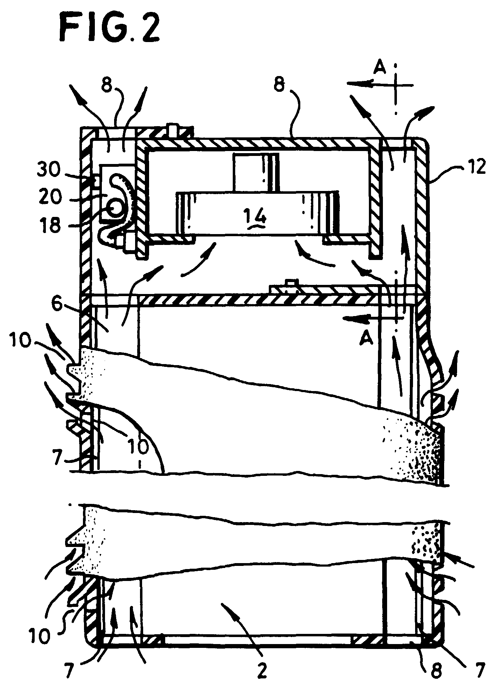

Figure 2 is a section through the equipment with its cover closed;

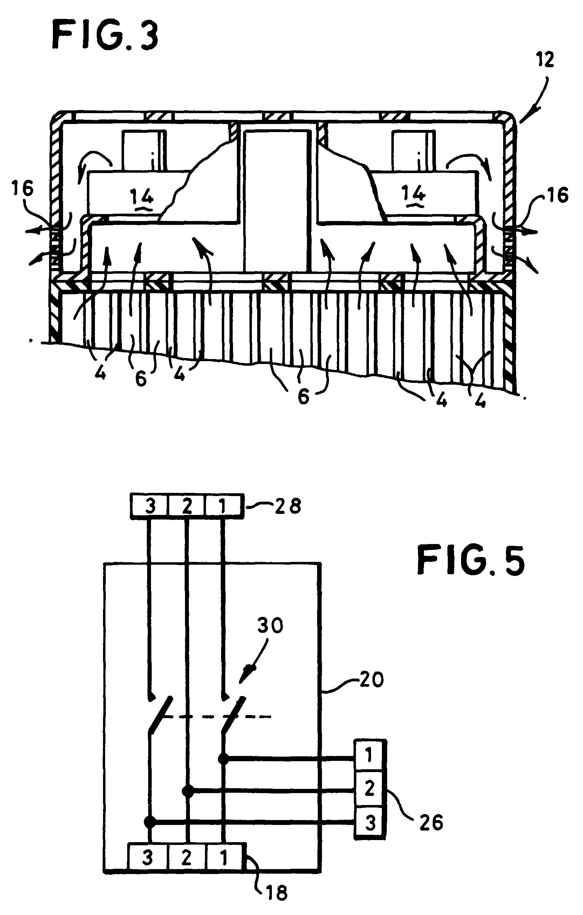

Figure 3 is a scrap sectional view at right angles to that of Figure 2;
Figure 4 has a pictorial view of a mains splitter box of the equipment of Figure 1; and
Figure 5 is a schematic circuit diagram of the mains splitter unit of Figure 4.

Referring to the drawings, radio transmitters and receivers, a processor, power units and other units (not shown) are contained by an external enclosure 2 which is surrounded by an outer case 3. The enclosure is environmentally sealed so that heat generated by the internal units has to be dissipated by the enclosure 2. To this end the enclosure 2 is provided with extended surfaces or fins 4 which define vertical channels 6 between them. The fins 4 extend into air passages 7 defined by the enclosure. Air circulates naturally through the passages 7 via vents 8 and louvres 10 and so through the channels 6 to cool the enclosure.

In some climates, natural convection may not be sufficient to cool the enclosure and its contents to a satisfactory operating temperature. An add on cooling unit 12 is provided containing fans 14 which draw air through the channels 6 and out through vents 16.

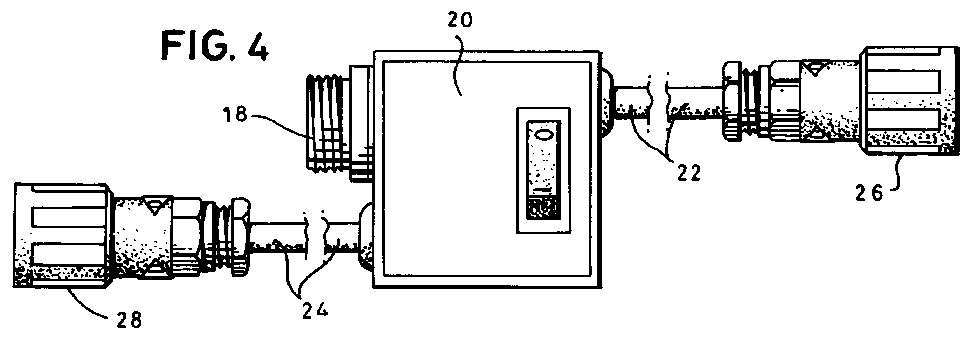

In order to avoid providing two mains cables one, for the fan unit and one for the equipment in the enclosure 2, one cable is used to connect to the mains supply (not shown). The cable terminates in a weather proof connector which is received by a connector 18 of a splitter unit 20. As may be seen from Figure 4, the mains supply is distributed from the connector to two flying leads 22 and 24 which terminate in respective connectors 26 and 28. The supply to the connector 26 is switched by a two pole switch 30.

If the cooling unit requires maintenance or replacement, it may be isolated by operation of the switch 30 without also powering down the base station equipment contained by the enclosure 2.

## Claims

1. Radio telecommunications equipment, comprising:
an enclosure mounted outdoors, the enclosure containing a radio transmitter and a radio receiver;
a cooling module mounted adjacent the enclosure to force air over the surface of the enclosure thereby to cool it;
a mains splitter unit having an mains inlet connected to a mains electrical supply by cable, and two mains outlets connected by cable and connectors a first outlet to power the transmitter and receiver in the enclosure and a second outlet to power the cooling module; and
a switch to isolate the second outlet from the mains supply.

2. Radio equipment as claimed in claim 1, constituting base station equipment in a mobile telecommunications network.

3. Radio equipment as claimed in claim 1 or 2, wherein the enclosure is formed with heat conductive extended surfaces extending vertically, in use, so as to define channels therebetween; the equipment including an outer case containing said enclosure and defining air passages into which the extended surfaces project, the outer case having vents to allow convection through the channels between the extended surfaces; the cooling module being located at or towards the upper end of the air passages to draw air therefrom.

4. Radio equipment as claimed in claim 3, wherein the splitter unit is a separate module mounted in the outer case.
